# EUROPEAN PATENT APPLICATION

(11) **EP 3 633 402 A1**
(43) Date of publication of application: **08.04.2020**
(21) Application number: 18198579.7
(22) Date of filing: 04.10.2018
(51) Int. Cl.: G01R 35/00

(54) **REMOTE CALIBRATION OF A TESTING DEVICE**

(71) Applicant: Schleich GmbH, 58675 Hemer (DE)
(72) Inventor: Lahrmann, Martin, 58675 Hemer (DE)
(74) Representative: Lohr, Jöstingmeier & Partner

(57) **Abstract**

A method (100) for calibrating a testing device (10), a computer program product for calibrating a testing device (10), a calibration device (50) for calibrating a testing device (10) and a testing device (10) for self-calibrating. The testing device (10) is calibrated by means of at least a material measure device (20) being connected to the testing device (10).

## Description

### Field of the invention

The invention relates to a method for calibrating a testing device. The invention further relates to a computer program product for calibrating a testing device, a calibration module for calibrating a testing device, a material measure device for calibrating a testing device, a calibration device for calibrating a testing device and a testing device for self-calibrating.

### Description of the related art

Testing devices are widely used by a plurality of manufacturers of electric or electronic devices for testing whether a manufactured electric or electronic device to be delivered complies with safety provisions or other regulations. Even clients of such manufacturers may use testing devices for repeatedly testing whether an electric or electronic device which has been received from a manufacturer complies with safety provisions or other regulations. The manufacturer of electric or electronic devices and the clients of a manufacturer of electric or electronic devices are referred to as users of the testing devices hereinafter.

Due to the intended use, in turn, the testing device itself has to comply with high accuracy requirements in order to reliably verify or falsify a compliance of a tested electric or electronic device at all times. However, a testing device originally having a required accuracy may change over time due to aging or damage and, consequently, may loose the required accuracy.

Therefore, a testing device has to be calibrated repeatedly and, in most cases, periodically, i.e. a specific calibration method has to be applied to the testing device in regular time intervals. The calibration method often requires the testing device to measure a material measure, i.e. acquire a measured value corresponding to the material measure within a normal operation of the testing device. A material measure to be used for calibration may be a resistive load, a capacity, an inductivity, an AC or DC voltage source, an AC or DC current source and the like. After the measurement the acquired measured value may be compared with a reference value associated with the material measure in order to assess an accuracy of the testing device.

The calibration is successful when the acquired measured value is within a predetermined range about the reference value. A successful calibration usually has to be certified by a manufacturer of the testing device or an independent institution calibration authority. The manufacturer of the device and the independent institution are referred to as a calibration authority hereinafter.

In practice, there are basically two ways for having a testing device calibrated.

First, the testing device may be transported to the calibration authority where the calibration method is applied to the testing device by a technician of the calibration authority. A negative consequence thereof is a long-term absence of the testing device from a normal location of the testing device which may be a factory of a user of the testing device. During the absence of the testing device a calibration cannot be carried out which may result in a delivery or manufacture delay.

Second, a service technician of the calibration authority may travel to the normal location of the testing device, i.e. the factory of the user of the testing device, and apply the calibration method to the testing device at the normal location. While this alternative helps to minimize a downtime of the test device, travelling of the service technician is expensive and, eventually, may not be possible short-term or later at a desired time.

### Summary of the invention

The object to be solved by the invention is to suggest a method for calibrating a testing device which overcomes the above-mentioned disadvantages and allows for calibrating the testing device both with a short downtime and at low cost. Other objects of the invention are to provide a computer program product for calibrating a testing device, a calibration module for calibrating a testing device, a material measure device for calibrating a testing device, a calibration device for calibrating a testing device and a testing device for self-calibrating.

Subject matter solving the preceding objects are described in the independent claim and the associated claims. The dependent claims relate to subject matter further improving the solutions of the independent and associated claims.

A method for calibrating a testing device according to the invention may comprise the following steps.

A material measure device to be used for calibration and providing at least one material measure to be measured is connected to a testing device. The connection may be established in the usual way, i.e. by plugging a corresponding cable, a specific measuring cable for example, both to the testing device and to the material measure device.

The testing device may be identified by a calibration module reading an identifier of the testing device which uniquely identifies the testing device. Further, the material measure device may be identified by the calibration module reading an identifier of the material measure device which uniquely identifies the material measure device. These identifications are for precisely documenting the calibration of the testing device.

After these preparative steps, a material measure to be used for calibration is selected. The selected material measure is identified by the calibration module reading an identifier of the material measure which uniquely identifies the material measure among the material measures provided by the material measure device. In case the material measure device only provides a single material measure the steps of selecting and identifying the material measure is not executed separately but is executed just by and along with identifying the material measure device.

For sake of comparison, a reference value corresponding to the selected material measure is read by the calibration module. Then, a measured value corresponding to the selected material measure is acquired by operating the testing device and subsequently read.

After that, a difference between the measured value and the reference value is calculated by the calibration module in order to assess an accuracy of the testing device.

The steps of selecting the material measure, identifying the material measure, reading the reference value, acquiring the measured value, reading the measured value and calculating the difference may be referred to as basic steps of the calibration method.

In case the calculated difference between the measured value and the reference value falls within a predetermined tolerance range, a digital calibration certificate is created at least partially by the calibration module for certifying a successful calibration of the testing device.

The predetermined tolerance range generally is a pair of signed values, i.e. a positive value and a negative value. The signed values correspond to positive differences and negative differences, respectively, and, thus, define a two-sided tolerance range about the reference value which covers measured values being larger than the reference value and measured values being smaller than the reference value. The pair of signed values may be asymmetrical, i.e. the absolute values of the positive value and the negative value may be different, in order to define asymmetric tolerance ranges. Also, one of the signed values may be zero, thus defining a one-sided tolerance range.

As the calibration certificate is digital, i.e. not on paper, it can be automatically generated at an arbitrary location and even be transmitted to an arbitrary location very easily. The digital format of the calibration certificate which may be, for example, the portable document format (PDF) renders the calibration method independent from a relative distance of the testing device and the calibrating authority and, thus, supports even a locally distributed calibration. Nevertheless, the digital calibration certificate may be printed in a sufficiently high quality at an arbitrary location, particularly at the location of the testing device, if ever needed on paper.

Preferably, the step of creating the digital calibration certificate comprises the steps of generating a digital calibration protocol comprising the identifier of the testing device, the identifier of the material measure device, the identifier of the material measure, the reference value and the measured value, by the calibration module, transmitting the generated digital calibration protocol to a calibration authority, by the calibration module, generating the digital calibration certificate based on the transmitted digital calibration protocol and receiving the generated digital calibration certificate from the calibration authority, by the calibration module. In this way, certifying a successful calibration of the testing device is reserved to the calibration authority even in case the basic steps of calibration are not executed under supervision of the calibration authority and/or are executed far away from the location of the calibration authority.

In a configuration like this, the digital calibration protocol is generated and transmitted at the location of the testing device and the digital calibration certificate is received at the location of the testing device while the digital calibration protocol is generated at the location of the calibration authority, i.e. by a server of the calibration authority. Alternatively the calibration certificate may be generated immediately by the calibration module without generating a calibration protocol before. According to a further embodiment, the calibration certificate may be generated by the calibration module at the location of the testing device without any step of transmitting or receiving.

Generating the digital calibration protocol may also comprise a step of encrypting the digital calibration protocol in order to not immediately disclose the calibration result to the user in detail. In these embodiments of the method, the encryption is done along with the generation of the digital calibration protocol at the location of the testing device. The calibration authority subsequently has to decrypt the digital calibration protocol before generating the digital calibration certificate. Encryption of the digital calibration protocol avoids misuse or manipulation of the calibration result and, thus, increases a security of the calibration method.

Ideally, in case the calculated difference exceeds a predetermined tolerance range, the method comprises the further steps of adjusting the testing device according to the calculated difference, acquiring a measured value corresponding to the material measure by operating the adjusted testing device and reading the acquired measured value, by the calibration module. In case the testing device has accessible adjustment means, the testing device is adjusted manually or automatically by the calibration module in order to reduce or preferably zero out the calculated difference. These steps may be repeated if needed. Adjusting the testing device allows for a successful calibration even in case the testing device initially does not comply with the accuracy requirements. Thus, transporting the testing device to a manufacturer thereof and, consequently long downtimes of the testing device, can be avoided in most cases.

Favorable embodiments of the method comprise successively selecting one of a plurality of material measures of the material measure device and, for each selected material measure, executing the further steps of identifying the selected material measure, by the calibration module reading an identifier of the material measure, reading a reference value associated with the selected material measure, by the calibration module, acquiring a measured value corresponding to the selected material measure by operating the testing device, reading the acquired measured value, by the calibration module, and calculating a difference between the measured value and the reference value, by the calibration module. Briefly summarized, the above-mentioned basic steps of calibration are repeated for each material measure to be used for calibrating the testing device. Thus, the downtime of the testing device due to calibration may be further shortened.

Other embodiments of the method comprise the further step of connecting a calibration device having the calibration module to at least the testing device for controlling at least the testing device. Using the calibration device is recommended for carrying out the method partially automatically in case the testing device is not self-calibrating.

Still other embodiments of the method comprise the further steps of connecting a reference device to the material measure device and identifying the reference device by the calibration module, reading an identifier of the reference device. The reference device has a valid calibration. Using the reference device allows for carrying out the method in case the material measure device has no reference values being assigned to the material measures, respectively. The calibrated reference device may also be integrated, i.e. build-in, in the material measure device which corresponds to a valid calibration of the material measure device not having any reference value. The material measure device, hence, has not to be calibrated itself which allows for arbitrarily using any material measure device which has no calibration.

In embodiments of the method using the reference device the step of reading the reference value may comprise the steps of acquiring a measured value corresponding to the material measure by operating the reference device and reading the acquired measured value from the reference device as the reference value, by the calibration module. In other words, the reference devices supplies the reference value as the measured value being acquired by means of a normal measuring operation of the reference device.

In preferable embodiments of the method the step of reading a reference value comprises reading a reference value assigned to the material measure from the material measure device, by the calibration module. These embodiments use a material measure device with a reference value being assigned to the material measure. Assigning a reference value to a material measure requires calibrating the material measure device. Using a calibrated material measure device reduces the effort for calibrating the testing device as a reference device is dispensable.

The method may comprise at least one of the steps of transporting at least one of the devices being different from the testing device to the testing device before calibration and transporting at least one of the devices being different from the testing device from the testing device after calibration. These steps allow for leaving the testing device at the location of a normal usage, i.e. in a factory of a user.

Preferably, at least one step of identifying comprises reading the identifier from a bar code, a data matrix, an RFID Chip or a memory location of the respective device. The bar code and the data matrix which has the general structure of a well-known QR code may be optically read by means of a corresponding scanner. The bar code or the data matrix have to be read manually. The RFID-Chip may be read by means of a corresponding transmitter/receiver. The memory location may be read by means of a corresponding digital interface. The RFID Chip and the memory location can be read automatically.

At least one step of transmitting and receiving is favorably done wirelessly or via a cable. The wireless transmission may, for instance, use a WLAN network or a mobile network. The transmission via a cable may be done by means of a wired network, i.e. a wired ethernet network or the like. Preferably, the transmission is based on an internet protocol like HTTP, FTP, SMTP or the like.

At least one step of connecting may be done wirelessly or using a cable. The connection related to acquiring a measured value, i.e. the basic operative connection between the testing device and the material measure device, is done using a cable which is manually plugged both to the testing device and to the material measure device. Any other connection is preferably provided wirelessly, i.e. over the air, for instance using WiFi or Bluetooth which simplifies the handling of the devices used in the method.

Ideally, at least one of the steps of acquiring, reading, adjusting, generating transmitting and receiving is executed automatically by a calibration module and at least one step of connecting is executed manually wherein particularly each manual step to be executed is instructed and/or each executed manual step is detected or confirmed. The calibration method is the easier to carry out the more steps are executed automatically. Only the above mentioned basic operative connections between the testing device and possibly the reference device on the one hand and the material measure device on the other hand will usually have to be provided manually by plugging a corresponding cable. Carrying out the calibration method is highly simplified to a user by instructing any manual step acoustically, i.e. by a means of a speaker, and/or visually, i.e. by means of a graphical display. The user, then, can skip reading a calibration manual or the like. Execution of each manual step may be manually confirmed by the user, i.e. by pressing a button, touching a display or clicking a mouse, or automatically detected by corresponding sensors or circuits of the devices used in the method.

A computer program product according to the invention for calibrating a testing device stores a calibration program for carrying out at least partially automatically an inventive calibration method. The calibration program may be stored on a CD, a DVD, USB stick or the like in the usual way.

Preferably, the calibration program is executable by a processor of a testing device for self-calibrating or the calibration program is executable by a processor of a calibration device for calibrating a testing device being connected to the calibration device. In other words, the calibration program may be loaded to and installed on any device and is configured to be used in the inventive calibration method.

A calibration module for calibrating a testing device according to the invention has a processor and a calibration program being executable by the processor in order to control at least the testing device for carrying out a calibration method according to the invention. The calibration module allows for at least partially automatically calibrating the testing device by automatically executing at least one step of the inventive calibration method and/or instructing a user for manually executing a step of the inventive calibration method.

A testing device for self-calibrating according to the invention is configured to carry out the inventive calibration method and has an inventive calibration module. In other words, the testing device has a processor for executing a calibration program being configured to control at least the testing device itself.

A material measure device for calibrating a testing device according to the invention is configured to carry out the inventive calibration method and has an inventive calibration module. In other words, the material measure device has a processor for executing a calibration program being configured to control at least the testing device being connected to the material measure device.

A calibration device according to the invention for calibrating a testing device is configured to carry out the inventive calibration method and has an inventive calibration module. In other words, the material measure device has a processor for executing the calibration program being configured to control at least the testing device being connected to the calibration device.

It is an essential advantage of the inventive method for calibrating a testing device that a service technician has not to be involved in calibrating the testing device due to which the testing device may be calibrated by a user both with short down-time and at low cost. In other words, the user of the testing device may easily and at any time apply the calibration method to the testing device while certifying a successful calibration of the testing device may still be reserved to a calibration authority.

### Description of Drawings

The invention will be described below by way of exemplary embodiments with reference to the drawings, but without any limitation of the general inventive concept.
- Figure 1: shows an arrangement for carrying out a first embodiment of a method according to the invention.
- Figure 2: shows an arrangement for carrying out a second embodiment of a method according of the invention.
- Figure 3: shows an arrangement for carrying out a third embodiment of a method according to the invention.
- Figure 4: shows an arrangement for carrying out a fourth embodiment of a method according of the invention.
- Figure 5: shows a flow chart summarizing the embodiments corresponding to the arrangements shown in figures 1 to 4.

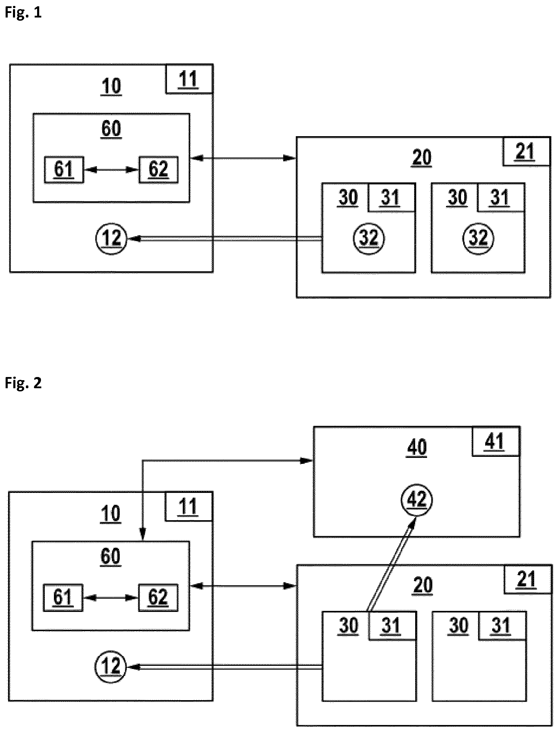

In figure 1 an arrangement for carrying out a preferred first embodiment of a method 100 according to the invention is shown. The arrangement comprises a testing device 10 for self-calibrating and a material measure device 20 having a plurality of material measures 30. The testing device 10, the material measure device 20 and each material measure 30 have readable identifiers 11, 21 and 31, respectively.

The material measure device 20 further has a plurality of readable reference values 32 being assigned to the material measures 30, respectively, i.e. the material measure device 20 has a certified calibration.

The testing device 10 is configured to carry out the calibration method 100 and has a processor 61 and a calibration program 62 being executable by the processor 61. The calibration program 62 may have been transferred to the testing device 10 from a computer program product (not shown) storing the calibration program 62, i.e. from a CD, a DVD, a USB memory stick or the like.

The processor 61 and the calibration program 62 are part of a calibration module 60 of the testing device 10. The calibration module 60 is configured to control the testing device 10 and the material measure device 20.

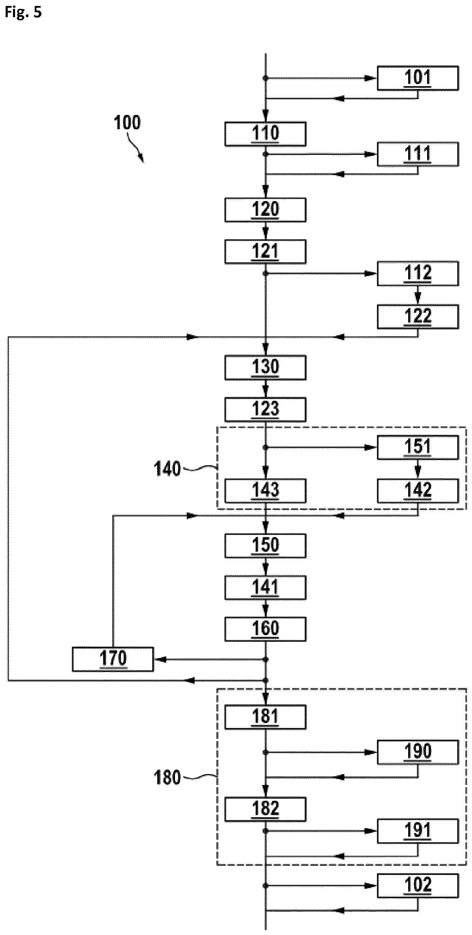

As can be seen from figure 5, first of all, the material measure device 20 may be transported 101 to the testing device 10. This is required in case the material measure device 20 is located far from the testing device 10. The calibration module 60 takes control after starting the calibration program 62 to be executed by the processor 61. Under the control of the calibration module 60, the following steps are executed.

The material measure device 20 is connected to the testing device 10. The testing device 10 and the material measure device 20 are identified by the calibration module 60 reading the identifiers 11, 21 of the respective devices 10, 20.

Then, a material measure 30 to be used for calibration is selected 130 and identified 123 by the calibration module 60 reading an identifier 31 of the material measure 30. A reference value 32 associated with the selected material measure 30 is read 140 by the calibration module 60 reading 143 a reference value 32 assigned to the material measure 30 from the material measure device 20. After that, a measured value 12 corresponding to the selected material measure 30 is acquired 150 by operating the testing device 10. The measured value 12 is read 141 by the calibration module 60. A difference between the measured value 12 and the reference value 32 is calculated 160 by the calibration module 60 in a further step.

In case the calibration of the testing device 10 uses a plurality of material measures 30 of the material measure device 20, the material measures 30 to be used for calibration are selected 130 successively, and the steps of identifying 123, reading 140, acquiring 150, reading 141 and calculating 160 are repeated for each selected material measure 30.

In case a calculated difference exceeds a predetermined tolerance range, the testing device 10 is adjusted 170 according to the calculated difference. Then, a measured value 12 is acquired 150 corresponding to the material measure 30 by operating the adjusted testing device 10, and the acquired measured value 12 is read 141 by the calibration module 60. The steps of adjusting 170, acquiring 150 and reading 141 may be repeated until the calculated difference falls within a predetermined tolerance range.

In case each calculated difference falls within the respective predetermined tolerance range a digital calibration certificate is created 180 at least partially by the calibration module. Creating 180 the digital calibration certificate comprises generating 181 a digital calibration protocol comprising the identifier 11 of the testing device 10, the identifier 21 of the material measure device 20, the identifier 31 of each material measure 30, each reference value 32 and each measured value 12, by the calibration module 60, transmitting 190 the generated digital calibration protocol to a calibration authority, by the calibration module 60, generating 182 the digital calibration certificate based on the transmitted digital calibration protocol and receiving 191 the generated digital calibration certificate from the calibration authority, by the calibration module 60.

At the end, the material measure device 20 may be transported 102 away from the testing device 10.

In figure 2 an arrangement for carrying out a second embodiment of a method 100 according to the invention is shown. The arrangement comprises a testing device 10 for self-calibrating, a material measure device 20 having a plurality of material measures 30 and a reference device 40. The testing device 10, the material measure device 20, and the reference device 40 have readable identifiers 11, 21 and 41, respectively.

The arrangement shown in figure 2 differs from the arrangement shown in figure 1 by the additional reference device 40 and is recommended, but not limited to, in case the material measure device 20 does not have readable reference values being assigned to the material measures 30, i.e. the material measure device 10 has no certified calibration.

The testing device 10 is configured to carry out the calibration method 100 and has a processor 61 and a calibration program 62 being executable by the processor 61. The calibration program 62 may have been transferred to the testing device 10 from a computer program product (not shown) storing the calibration program 62, i.e. from a CD, a DVD, a USB memory stick or the like.

The processor 61 and the calibration program 62 are part of a calibration module 60 of the testing device 10. The calibration module 60 is configured to control the testing device 10 and the material measure device 20.

As can be seen from figure 5, first of all, the material measure device 20 and/or the reference device 40 may be transported 101 to the testing device 10. This is required in case the material measure device 20 and/or the reference device 40 is located far from the testing device 10. The calibration module 60 takes control after starting the calibration program 62 to be executed by the processor 61. Under the control of the calibration module 60, the following steps are executed.

The material measure device 20 is connected 112 to the testing device 10 and the reference device 40 is connected to the material measure device 20 and to the testing device 10. The testing device 10, the material measure device 20 and the reference device 40 are identified by the calibration module 60 reading the identifiers 11, 21, 41 of the respective devices 10, 20, 40.

Further steps are, with one exception, identical to the steps executed by the arrangement shown in figure 1. The only exception relates to reading 140 the reference value 42. Instead of reading 143 the reference value 32 from the material measure device 20, a measured value corresponding to the material measure 30 is acquired 151 by operating the reference device 40 and the measured value acquired by the reference device 40 is read 142 by the calibration module 60 from the reference device 40 as the reference value 42.

Another difference from figure 1 is that the digital calibration protocol additionally comprises the identifier 41 of the reference device 40.

At the end, the material measure device 20 and/or the reference device 40 may be transported 102 away from the testing device 10.

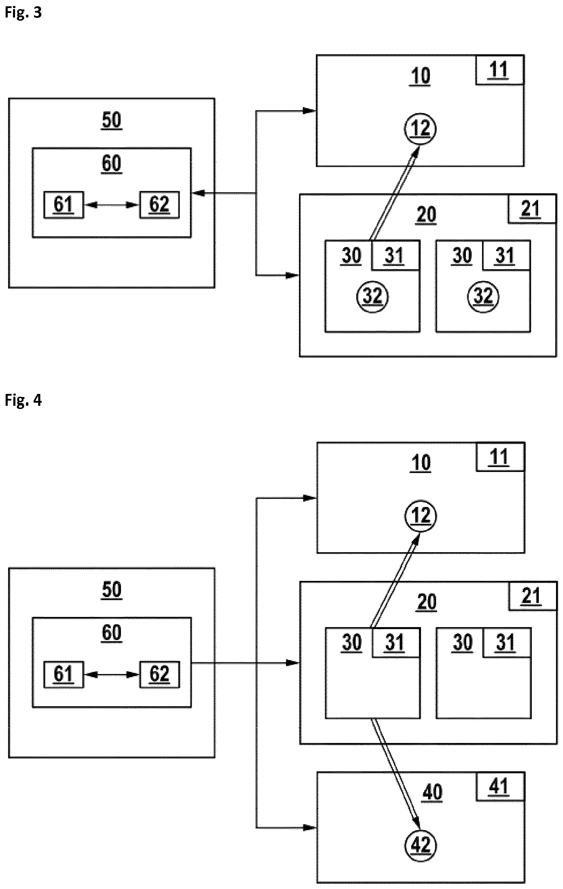

In figure 3 an arrangement for carrying out a third embodiment of a method 100 according to the invention is shown. The arrangement comprises a testing device 10 to be calibrated, a material measure device 20 having a plurality of material measures 30 and a calibration device 50. The testing device 10, the material measure device 20 and each material measure 30 have readable identifiers 11, 21 and 31, respectively.

The arrangement shown in figure 3 differs from the arrangement shown in figure 1 by the additional calibration device 50 and is recommended, but not limited to, in case the testing device 10 is not equipped for self-calibrating, i.e. the testing device 10 has no calibration module.

The calibration device 50 is configured to carry out the calibration method 100 and has a processor 61 and a calibration program 62 being executable by the processor 61. The calibration program 62 may have been transferred to the testing device 10 from a computer program product (not shown) storing the calibration program 62, i.e. from a CD, a DVD, a USB memory stick or the like.

The processor 61 and the calibration program 62 are part of a calibration module 60 of the calibration device 50. The calibration module 60 is configured to control the testing device 10 and the material measure device 20.

As can be seen from figure 5, first of all, the material measure device 20 and/or the calibration device 50 may be transported 101 to the testing device 10. This is required in case the material measure device 20 and/or the calibration device 50 is located far from the testing device 10. The calibration module 60 takes control after starting the calibration program 62 to be executed by the processor 61. Under the control of the calibration module 60, the following steps are executed.

The material measure device 20 is connected to the testing device 10 and the calibration device 50 is connected to the testing device 10 and to the material measure device 20. The testing device 10 and the material measure device 20 are identified by reading the identifiers 11, 21 of the respective devices 10, 20.

Further steps are identical to the steps executed by the arrangement shown in figure 1. However, in this arrangement it is the calibration device 50 to carry out the calibration method 100 instead of the testing device 10.

At the end, the material measure device 20 and/or the calibration device 50 may be transported 102 away from the testing device 10.

In figure 4 an arrangement for carrying out a fourth embodiment of a method 100 according to the invention is shown. The arrangement comprises a testing device 10 to be calibrated, a material measure device 20 having a plurality of material measures 30, a reference device 40 and a calibration device 50. The testing device 10, the material measure device 20 and the reference device 40 have readable identifiers 11, 21 and 41, respectively.

The arrangement shown in figure 4 differs from the arrangement shown in figure 2 by the additional calibration device 50 and is recommended, but not limited to, in case the testing device 10 is not equipped for self-calibrating, i.e. the testing device 10 has no calibration module, and the material measure device 20 does not have readable reference values being assigned to the material measures 30, i.e. the material measure device 10 has no certified calibration.

The calibration device 50 is configured to carry out the calibration method 100 and has a processor 61 and a calibration program 62 being executable by the processor 61. The calibration program 62 may have been transferred to the testing device 10 from a computer program product (not shown) storing the calibration program 62, i.e. from a CD, a DVD, a USB memory stick or the like.

The processor 61 and the calibration program 62 are part of a calibration module 60 of the calibration device 50. The calibration module 60 is configured to control the testing device 10, the material measure device 20 and the reference device 40.

As can be seen from figure 5, first of all, the material measure device 20, the reference device 40 and/or the calibration device 50 may be transported 101 to the testing device 10. This is required in case the material measure device 20, the reference device 40 and/or the calibration device 50 is located far from the testing device 10. The calibration module 60 takes control after starting the calibration program 62 to be executed by the processor 61. Under the control of the calibration module 60, the following steps are executed.

The material measure device 20 is connected to the testing device 10, the reference device 40 is connected to the material measure device 20 and the calibration device 50 is connected to the testing device 10, the material measure device 20 and the reference device 40. The testing device 10, the material measure device 20 and the reference device 40 are identified by the calibration module reading the identifiers 11, 21, 41 of the respective devices 10, 20, 40.

Further steps are identical to the steps executed by the arrangement shown in figure 2. However, in this arrangement it is the calibration device 50 to carry out the calibration method 100 instead of the testing device 10.

At the end, the material measure device 20, the reference device 40 and/or the calibration device 50 may be transported 102 away from the testing device 10.

The skilled person appreciates that in further embodiments also the material measure device 20 may have the calibration module 60 and will readily adapt the embodiments shown in figures 1 to 4 to this alternative.

In figure 5 a flow chart summarizing the embodiments corresponding to the arrangements shown in figures 1 to 4 is shown. At least one step, preferably each step, of identifying 120, 121, 122, 123 may comprise reading the identifier 11, 21, 31, 41 from a bar code, a data matrix, an RFID-Chip or a memory location of the respective device 10, 20, 30, 40. Further, at least one step, preferably each step, of transmitting 190 and receiving 191 may be done wirelessly or via a cable. Also at least one step, preferably each step, of connecting 110, 111, 112 may be done wirelessly or using a cable.

At least one of the steps, preferably each step, of acquiring 150, 151, reading 140, 141, 142, 143, adjusting 170, generating 181, 182, transmitting 190 and receiving 191 is executed automatically by the calibration module 60 and at least one step of connecting 110, 111, 112, preferably only the steps of connecting 110, 112, is executed manually. Each manual step to be executed may be instructed by the calibration module 60 and/or each executed manual step may be automatically detected by the calibration module 60 or manually confirmed to the calibration module 60.

It is to be understood that figure 5 comprises any above-mentioned step of method 100 regardless of potentially impossible or useless combinations of steps. In other words, figure 5 comprises combinations of steps which cannot or at least usually will not be executed.

Apart from that, the order of the steps of the method 100 and the transitions between the steps is shown exemplarily only, i.e. one or more steps of the method 100 may be ordered differently and/or transitions may be chosen differently without departing from the general concept of the invention. Also omitting one or more of the shown steps does not depart from the general concept of the invention.

The centered vertical step sequence needs the lowest number of devices and, hence, is preferred. It may be applied to the arrangement shown in figure 1 as has been described above. It is noted that the general steps of reading 140 a reference value and creating 180 a digital calibration protocol may be realized differently without departing from the general concept of the invention. For example, the digital calibration certificate may be generated 182 without generating 181 a digital calibration protocol before in case transmitting 191 and receiving 192 is not necessary. The latter will usually be the case if a service technician of the calibration authority himself carries out the method 100 with direct access to the testing device 10.

Some step sequences left and right to the centered vertical step sequence need at least one additional device. They may be applied to an arrangement shown in figures 2 to 4 as has been described above.

### List of reference numerals

- 10: testing device
- 11: identifier
- 12: measured value
- 20: material measure device
- 21: identifier
- 30: material measure
- 31: identifier
- 32: reference value
- 40: reference device
- 41: identifier
- 42: reference value
- 50: calibration device
- 60: calibration module
- 61: processor
- 62: calibration program
- 100: method for calibrating
- 101: transporting
- 102: transporting
- 110: connecting
- 111: connecting
- 112: connecting
- 120: identifying
- 121: identifying
- 122: identifying
- 123: identifying
- 130: selecting
- 140: reading
- 141: reading
- 142: reading
- 143: reading
- 150: acquiring
- 151: acquiring
- 160: calculating
- 170: adjusting
- 180: getting
- 181: generating
- 182: generating
- 190: transmitting
- 191: receiving

## Claims

1. A method (100) for calibrating a testing device (10), comprising the steps:
- connecting (110) a material measure device (20) providing at least one material measure (30) to a testing device (10);
- identifying (120) the testing device (10), by a calibration module (60) reading an identifier (11) of the testing device (10);
- identifying (121) the material measure device (20), by the calibration module (60) reading an identifier (21) of the material measure device (20);
- selecting (130) a material measure (30) to be used for calibration;
- identifying (123) the selected material measure (30), by the calibration module (60) reading an identifier (31) of the material measure (30);
- reading (140) a reference value (32, 42) associated with the selected material measure (30), by the calibration module (60);
- acquiring (150) a measured value (12) corresponding to the selected material measure (30) by operating the testing device (10);
- reading (141) the acquired measured value (12), by the calibration module (60),
- calculating (160) a difference between the measured value (12) and the reference value (32, 42), by the calibration module (60)
**characterized by** the further step:
- creating (180) a digital calibration certificate in case the calculated difference falls within a predetermined tolerance range, at least partially by the calibration module (60).

2. The method according to claim 1,
**characterized in that**
the step of creating (180) the digital calibration certificate comprises the steps:
- generating (181) a digital calibration protocol comprising the identifier (11) of the testing device (10), the identifier (21) of the material measure device (20), the identifier (31) of the material measure (30), the reference value (32, 42) and the measured value (12), by the calibration module (60);
- transmitting (190) the generated digital calibration protocol to a calibration authority, by the calibration module (60);
- generating (182) the digital calibration certificate based on the transmitted digital calibration protocol;
- receiving (191) the generated digital calibration certificate from the calibration authority, by the calibration module (60).

3. The method according to one of claims 1 or 2, comprising the further steps in case the calculated difference exceeds a predetermined tolerance range:
- adjusting (170) the testing device (10) according to the calculated difference;
- acquiring (150) a measured value (12) corresponding to the material measure (30) by operating the adjusted testing device (10);
- reading (141) the acquired measured value (12), by the calibration module (60).

4. The method according to one of claims 1 to 3,
**characterized by** successively selecting (130) one of a plurality of material measures (30) of the material measure device (20) and executing the further steps for each selected material measure (30):
- identifying (123) the selected material measure (30) to be used for calibration, by the calibration module (60) reading an identifier (31) of the material measure (30);
- reading (140) a reference value (32, 42) associated with the selected material measure (30), by the calibration module (60);
- acquiring (150) a measured value (12) corresponding to the selected material measure (30) by operating the testing device (10);
- reading (141) the acquired measured value (12), by the calibration module (60);
- calculating (160) a difference between the measured value (12) and the reference value (32, 42), by the calibration module (60).

5. The method according to one of claims 1 to 4,
**characterized by** the further step:
connecting (111) a calibration device (50) having the calibration module (60) to at least the testing device (10) for controlling at least the testing device (10).

6. The method according to one of claims 1 to 5,
**characterized by** the further steps:
- connecting (112) a reference device (40) to the material measure device (20);
- identifying (122) the reference device (40), by the calibration module (60) reading an identifier (41) of the reference device (40).

7. The method according to claim 6,
**characterized in that**
the step of reading (140) the reference value (32) comprises the steps:
- acquiring (151) a measured value corresponding to the material measure (30) by operating the reference device (40);
- reading (142) the acquired measured value from the reference device (40) as the reference value (42), by the calibration module (60).

8. The method according to one of claims 1 to 5,
**characterized in that**
the step of reading (140) a reference value (32) comprises reading (143) a reference value (32) assigned to the material measure (30) from the material measure device (20), by the calibration module (60).

9. The method according to one of claims 1 to 8,
**characterized in that**
at least one step of identifying (120, 121, 122, 123) comprises reading the identifier (11, 21, 31, 41) from a bar code, a data matrix, an RFID-Chip or a memory location of the respective device (10, 20, 30, 40) and/or at least one step of transmitting (190) and receiving (191) is done wirelessly or via a cable and/or at least one step of connecting (110, 111, 112) is done wirelessly or using a cable.

10. The method according to one of claims 1 to 9,
**characterized in that**
at least one of the steps of acquiring (150, 151), reading (140, 141, 142, 143), adjusting (170), generating (181, 182), transmitting (190) and receiving (191) is executed automatically by a calibration module (60) and at least one step of connecting (110, 111, 112) is executed manually wherein particularly each manual step to be executed is instructed and/or each executed manual step is detected or confirmed.

11. A computer program product for calibrating a testing device (10), storing a calibration program (62) for carrying out at least partially automatically a calibration method (100) according to one of claims 1 to 10.

12. A calibration module (60) for calibrating a testing device (10), having a processor (61) and a calibration program (62) being executable by the processor (61) in order to control at least the testing device (10) for carrying out a calibration method according to one of claims 1 to 10.

13. A testing device (10) for self-calibrating,
**characterized in that**
the testing device (10) is configured to carry out a calibration method (100) according to one of claims 1 to 10 and has calibration module (60) according to claim 12.

14. A material measure device (20) for calibration a testing device (10),
**characterized in that**
the material measure device (20) is configured to carry out a calibration method (100) according to one of claims 1 to 10 and has a calibration module (60) according to claim 12.

15. A calibration device (50) for calibrating a testing device (10),
**characterized in that**
the calibration device (50) is configured to carry out a calibration method (100) according to one of claims 1 to 10 and has a calibration module (60) according to claim 12.
